# EUROPÄISCHE PATENTANMELDUNG

(11) **EP 4 800 418 A1**
(43) Veröffentlichungstag der Anmeldung: **02.09.2026**
(21) Anmeldenummer: 25160899.8
(22) Anmeldetag: 28.02.2025
(51) Int. Cl.: G01R 33/38, G01R 33/3815

(54) **VORRICHTUNG ZUR KÜHLUNG EINES SUPRALEITENDEN MAGNETEN UND VERFAHREN ZUM BETRIEB**

(71) Anmelder: Siemens Healthineers AG, 91301 Forchheim (DE)
(72) Erfinder: Beck, Thomas, 91077 Dormitz (DE)
(74) Vertreter: Siemens Healthineers Patent Attorneys

(57) **Zusammenfassung**

Die Erfindung betrifft eine Magnetsteuerung für einen supraleitenden Feldmagneten eines Magnetresonanztomographen, den Magnetresonanztomographen und ein Verfahren zum Betrieb. Es wird eine Verfügbarkeit einer Ressource zum Kühlen des supraleitenden Magneten durch die Magnetsteuerung erfasst, ein erster Betriebsmodus in Abhängigkeit von der Verfügbarkeit eingestellt und der supraleitenden Feldmagneten gemäß dem ersten Betriebsmodus gekühlt, wobei keine Bilderfassung durch den Magnetresonanztomographen erfolgt.

## Beschreibung

### Unabhängig vom grammatikalischen Geschlecht eines bestimmten Begriffes sind Personen mit männlicher, weiblicher oder anderer Geschlechteridentität mit umfasst.

Die Erfindung betrifft einen Magnetresonanztomographen sowie ein Verfahren zum Betrieb des Magnetresonanztomographen bei Mangel an Kühlressourcen. Der Magnetresonanztomograph erfasst einen Ressourcenmangel und eine Magnetsteuerung geht in einen Betriebszustand mit reduziertem Energiebedarf.

Magnetresonanztomographen sind bildgebende Vorrichtungen, die zur Abbildung eines Untersuchungsobjektes Kernspins des Untersuchungsobjektes mit einem starken äußeren Magnetfeld ausrichten und durch ein magnetisches Wechselfeld zur Präzession um diese Ausrichtung anregen. Die Präzession bzw. Rückkehr der Spins aus diesem angeregten in einen Zustand mit geringerer Energie wiederum erzeugt als Antwort ein magnetisches Wechselfeld, das über Antennen empfangen wird.

Mit Hilfe von magnetischen Gradientenfeldern wird den Signalen eine Ortskodierung aufgeprägt, die nachfolgend eine Zuordnung von dem empfangenen Signal zu einem Volumenelement ermöglicht. Das empfangene Signal wird dann ausgewertet und eine dreidimensionale bildgebende Darstellung des Untersuchungsobjektes bereitgestellt. Zum Empfang des Signals werden vorzugsweise lokale Empfangsantennen, sogenannte Lokalspulen verwendet, die zur Erzielung eines besseren Signal-Rauschabstandes unmittelbar am Untersuchungsobjekt angeordnet werden.

Die Energieaufnahme eines Magnetresonanztomographen für die Kühlung des supraleitenden Feldmagneten ist erheblich. Darüber hinaus werden Ressourcen benötigt wie eine Wärmesenke für die abgeführte Wärme, beispielsweise in Form eines Kühlwasserkreislaufs. Steht eine der Ressourcen nicht in ausreichender Menge zur Verfügung, besteht die Gefahr, dass der supraleitende Feldmagnet sich erwärmt und quencht.

Das Abkühlen des supraleitenden Feldmagneten danach erfordert eine lange Zeit, auch wenn der Feldmagnet nicht beschädigt wurde.

Es ist daher eine Aufgabe der Erfindung, eine Magnetsteuerung, einen Magnetresonanztomographen und ein Verfahren zum Betrieb des Magnetresonanztomographen bereitzustellen, das eine längere Überbrückung eines Ressourcenmangels der Kühlung erlaubt.

Diese Aufgabe wird von einem Verfahren nach Anspruch 1 sowie einem Magnetresonanztomographen nach Anspruch 8 und einem Verfahren nach Anspruch 9 gelöst.

Die erfindungsgemäße Magnetsteuerung ist für einen supraleitenden Feldmagneten eines Magnetresonanztomographen vorgesehen. Unter Magnetsteuerung wird dabei im Sinne der Erfindung nicht allein eine Steuerung in Form eines Steuerprozessors verstanden, sondern auch Aktoren, insbesondere ein Kühlaggregat zur Kühlung des supraleitenden Magneten.

Die erfindungsgemäße Magnetsteuerung ist ausgebildet, einen ersten Betriebsmodus und einen zweiten Betriebsmodus des supraleitenden Feldmagneten einzustellen. Unter Betriebsmodi werden dabei Zustände der Magnetsteuerung und damit des von der Magnetsteuerung betriebenen supraleitenden Feldmagneten verstanden. Beispielsweise werden die Betriebsmodi durch Parametersätze eingestellt, die Sollwerte für Sensoren an dem supraleitenden Magneten angeben, die durch die Aktoren, beispielsweise das Kühlaggregat erreicht werden sollen. Die Betriebsmodi zeichnen sich vorzugsweise durch eine quasistationäre Eigenschaft des Magneten aus, also dass sich dessen Eigenschaften wie Temperatur und/oder Magnetfeld bei Betrieb der Magnetsteuerung mit dem jeweiligen Parametersatz nicht oder nur geringfügig ändert.

Der erste Betriebsmodus ist erfindungsgemäß ein Betriebsmodus mit reduziertem Kühlressourcenverbrauch. Erfindungsgemäß wird der reduzierte Kühlressourcenverbrauch erzielt, indem eine Kühlleistung des Kühlaggregats durch die Magnetsteuerung graduell verringert wird, aber das Kühlaggregat nicht ausgeschaltet bzw. auf Null gesetzt wird. Details zu möglichen Ausführungsformen sind nachfolgend zu den Unteransprüchen ausgeführt. Während sich die Magnetsteuerung in dem ersten Betriebsmodus befindet, bleibt die supraleitende Eigenschaft des Magnetresonanztomographen erhalten, d.h. die Temperatur des supraleitenden Feldmagneten steigt nicht über eine Sprungtemperatur.

Der zweite Betriebsmodus ist erfindungsgemäß ein Betriebsmodus mit einer verbesserten Magnetfeldqualität im Vergleich zu dem ersten Betriebszustand für eine Magnetresonanzaufnahme. Beispielsweise kann es sich um einen Zustand mit besonders homogener Feldstärke handeln. Insbesondere gewährleistet der zweite Betriebsmodus einen stabilen Betrieb des supraleitenden Magneten während der Bilderfassung, ohne dass durch die Bilderfassung die Gefahr für ein Quenching erhöht wird.

Das erfindungsgemäße Verfahren ist zum Betrieb eines erfindungsgemäßen Magnetresonanztomographen mit einer erfindungsgemäßen Magnetsteuerung vorgesehen.

Das Verfahren weist den Schritt auf, eine Verfügbarkeit einer Ressource zum Kühlen des supraleitenden Feldmagneten durch die Magnetsteuerung zu erfassen. Denkbar sind beispielsweise Sensoren, die eine Temperatur der Umgebung oder des Kühlwassers erfassen und an die Magnetsteuerung weitergeben. Denkbar ist aber auch eine Kommunikationsschnittstelle, über die die Magnetsteuerung von der Haustechnik oder externen Vorkühlern Information über die Verfügbarkeit der Kühlressourcen erhält. Bei elektrischer Energie kann die Information beispielsweise auch von einem Sensor zur Spannungsüberwachung oder einer USV kommen.

In einem weiteren Schritt stellt die Magnetsteuerung den ersten Betriebsmodus in Abhängigkeit von der Verfügbarkeit der Ressource ein. Vorzugsweise wird der erste Betriebsmodus eingestellt, wenn eine Kühlressource nicht oder nur in verringertem Maß verfügbar ist.

Entsprechend kann der zweite Betriebsmodus von der Magnetsteuerung wieder eingestellt werden, wenn die Kühlressource in ausreichendem Maß verfügbar ist. Dies kann durch den bereits beschriebenen Schritt Erfassen einer Verfügbarkeit durch die Magnetsteuerung festgestellt werden.

In einem weiteren Schritt wird der supraleitende Feldmagnet entsprechend dem ersten Betriebsmodus gekühlt. Dies kann, wie nachstehend zu den Unteransprüchen dargelegt erfolgen, indem veränderte Sollwerte für eine Regelung des Kühlaggregats bereitgestellt werden. Insbesondere erfolgt bei einer Kühlung in dem ersten Betriebsmodus keine Bilderfassung durch den Magnetresonanztomographen.

Auf vorteilhafte Weise ermöglicht der erste Betriebsmodus durch seinen reduzierten Kühlressourcenverbrauch ein längeres Aufrechterhalten des supraleitenden Zustandes.

Weitere vorteilhafte Ausführungsformen sind zu den Unteransprüchen angegeben.

In einer möglichen Ausführungsform der erfindungsgemäßen Magnetsteuerung ist der erste Betriebsmodus ausgelegt, ein Quenching des supraleitenden Magneten nur ohne Magnetresonanzmessung zu verhindern. Mit anderen Worten, die Betriebsparameter für den supraleitenden Magneten sind in dem ersten Betriebsmodus so eng bzw. knapp ausgelegt bzw. vorgegeben, dass ein Quenching nur ohne zusätzliche thermische Belastung und/oder magnetische Belastung wie beispielsweise durch Gradientenfelder einer Bilderfassung vermieden wird. Die Betriebsparameter, die beispielsweise Sollwerte für maximale Temperatur und/oder Magnetfelder an verschieden Punkten des supraleitenden Magneten vorgeben, vorzugsweise an Orten mit Sensoren, können dann nahe an den theoretischen Grenzwerten für die Sprungtemperatur bei dem dortigen statischen Magnetfeld sein.

Auf vorteilhafte Weise ermöglicht der Ausschluss zusätzlicher thermischer und/oder magnetischer Belastungen eine Aufrechterhaltung der Supraleitung bei höheren Temperaturen und damit reduzierter Kühlleistung.

In einer denkbaren Ausführungsform der erfindungsgemäßen Magnetsteuerung weist die Magnetsteuerung Kühlaggregat für den supraleitenden Magneten auf. Das Kühlaggregat kann beispielsweise ein Pulsröhrenkühler mit einem Kompressor sein. Das Kühlaggregat weist einstellbare unterschiedliche Leistungsstufen auf. Insbesondere weist das Kühlaggregat mindestens eine weitere reduzierte Leistungsstufe zwischen einem ausgeschalteten Zustand und einem permanent eingeschalteten Zustand mit maximaler Kühlleistung auf. Die Magnetsteuerung ist ausgebildet, in dem ersten Betriebsmodus das Kühlaggregat mit der reduzierten Leistungsstufe des Kühlaggregats zu betreiben, bei der die Kühlleistung kleiner ist als bei der maximalen Leistungsstufe bzw. dem permanent eingeschalteten Zustand.

Vorzugsweise ist die Kühlleistung des Kühlaggregats in der reduzierten Leistungsstufe konstant bzw. im Wesentlichen konstant, sodass eine Temperatur des supraleitenden Magneten in diesem reduzierten Leistungszustand bzw. dem ersten Betriebsmodus nicht oder um weniger als 0,1 K, 1 K oder 5 K schwankt, abgesehen von einem Einschwingen der Temperatur bei einem Wechsel von einem anderen Betriebsmodus in diesen ersten Betriebsmodus. Bei dem oben genannten Pulsröhrenkühler kann dies beispielsweise durch einen regelbaren Kompressor erreicht werden.

Auf vorteilhafte Weise kann durch ein Kühlaggregat mit einer reduzierten Leistungsstufe einfach ein reduzierter Kühlressourcenbedarf realisiert werden und gleichzeitig ein Verbleiben des supraleitenden Feldmagneten in einem sicheren Zustandsbereich ohne Quenching sichergestellt werden.

In einer denkbaren Ausführungsform der erfindungsgemäßen Magnetsteuerung gibt der erste Betriebsmodus einen ersten Magnetparametersatz an. Dieser kann beispielsweise eine Temperatur an einem Sensor an dem supraleitenden Magneten vorgeben, die nicht überschritten werden darf. Die Temperatur kann auch in Abhängigkeit von einer Magnetfeldstärke an dem Ort des Sensors oder einem anderen Ort an dem supraleitenden Magneten vorgeben sein. Denkbar ist auch ein Druck eines Kühlmittels, beispielsweise Helium, der nicht überschritten werden darf. Vorzugsweise hängt der Druck wiederum von der Temperatur des supraleitenden Magneten ab.

Bei Einhaltung des Parametersatzes für den ersten Betriebsmodus durch die Magnetsteuerung liegt für den supraleitenden Magneten eine vorbestimmte thermische und/oder magnetische Belastbarkeit für den supraleitenden Magneten vor, die geringer ist als in dem zweiten Betriebsmodus. Unter Einhaltung des Parametersatzes ist dabei zu verstehen, dass die durch den Parametersatz vorgegebenen Sollwerte mit einer vorbestimmten jeweiligen maximalen erlaubten Abweichung der Sensorwerte von den Sollwerten eingehalten werden. Diese Sollwerte geben dabei einen Zustand an, der einer kleineren magnetischen und/oder thermischen Belastbarkeit des Magneten entsprechen im Vergleich zu dem zweiten Betriebsmodus. Sollwerte können beispielsweise für Temperatur, Druck oder die Magnetfeldstärke vorgegeben werden. Vorzugsweise sind die Parameter derart von den Sollwerten abhängig, dass ein größerer Sollwert auch mit einem größeren Parameterwert korrespondiert, andernfalls ist dieses Merkmal in äquivalenter Weise anzuwenden, d.h. der Parameterwert für den zweiten Betriebsmodus ist entsprechen kleiner. Vorzugsweise ist die Abweichung eines Ist-Werts für den zu dem Parametersatz korrespondierende Sollwert kleiner als 0,1% 1% oder 5%.

In einem einfachen Beispiel kann der Sollwert eine Temperatur sein, die der supraleitende Feldmagnet nicht überschreiten darf, damit er bei dem bestehenden durch den supraleitenden Strom vorgegebenen Magnetfeld nicht quencht. Der Parameter kann dann eine Leistung sein, mit der das Kühlaggregat zu betreiben ist, um diese Temperatur zu halten. Der Parameter kann mit dieser Leistung über eine Funktion oder einen Faktor verknüpft sein, beispielsweise einer Proportionalitätskonstante. Indirekt kann die Temperatur auch über einen Gasdruck für ein Kühlmittel wie Helium gegeben sein.

Parametersätze können durch Berechnung oder auch Versuche ermittelt werden und in einem Speicher der Magnetsteuerung für vorbestimmte Betriebsmodi gespeichert werden
Auf vorteilhafte Weise können durch Parametersätze schnell unterschiedliche Szenarien mit komplexen physikalischen Zusammenhängen vorgegeben und eingestellt werden.

In einer möglichen Ausführungsform der erfindungsgemäßen Magnetsteuerung gibt der zweite Betriebsmodus einen zweiten Parametersatz an bzw. vor. Der zweite Parametersatz führt im Betrieb mit der Magnetsteuerung zu einer besseren Eignung des Magneten für eine Bildgebung. Das kann beispielsweise eine höhere Homogenität des Magnetfeldes sein, aber auch eine verbesserte Stabilität des Magnetfeldes bei der Bilderfassung. Gleichzeitig ist der Parametersatz des ersten Betriebsmodus keine Teilmenge des Parametersatzes für den zweiten Betriebsmodus ist, mit anderen Worten, Feldmagnet und eine Magnetsteuerung, die mit dem ersten Parametersatz quasistationär betrieben werden, erfüllen nicht die Bedingungen, die ein Feldmagnet und eine Magnetsteuerung im Betrieb mit dem zweiten Parametersatz erfüllt. Insbesondere ist im ersten Betriebsmodus ein reduzierter Bedarf an mindestens einer Kühlressource gegenüber dem zweiten Betriebsmodus gegeben, während im zweiten Betriebsmodus eine Bilderfassung ohne Quenching möglich ist, wohingegen im ersten Betriebsmodus ein Quenching nur ohne Bilderfassung sicher ausgeschlossen ist. Dies kann beispielsweise erreicht werden, indem ein Betrieb mit dem zweiten Parametersatz zu einer niedrigere Magnettemperatur führt, indirekt auch zu einem niedrigeren Gasdruck des Kühlmittels, und damit mehr Spielraum für eingetragene Wärme und Magnetfelder durch eine Bilderfassung erlaubt, was gleichzeitig aber auch zu einem höheren Verbrauch an Kühlressourcen führt.

Es ist aber denkbar, dass der zweite Parametersatz zwar zu einem erhöhten Kühlressourcenverbrauch führt als der erste Parametersatz, aber dennoch zu einem geringeren Kühlressourcenverbrauch als in einem Betrieb mit permanenter maximaler Leistung des Kühlaggregats.

Auf vorteilhafte Weise erlaubt der zweite Parametersatz einen Betrieb mit Bilderfassung, hat aber dennoch einen reduzierten Bedarf gegenüber einem Dauerbetrieb mit maximaler Leistung und kann dennoch die hohe Leistung Nutzen, wenn temporär ein hoher Wärmeeintrag erfolgt.

In einer denkbaren Ausführungsform der erfindungsgemäßen Magnetsteuerung ist die Magnetsteuerung ausgebildet, den ersten Betriebsmodus in Abhängigkeit von einer Verfügbarkeit einer Kühlressource einzustellen. Dazu ist es denkbar, dass die Magnetsteuerung Sensoren zum Erfassen einer Verfügbarkeit einer Kühlressource aufweist, beispielsweise einen Druck- oder Durchflussmesser für Kühlwasser oder ein anderes sekundäres Kühlmittel oder einen Temperatursensor zum Erfassen der Temperatur des sekundären Kühlmittels. Auch sind Sensoren zur Überwachung der Stromversorgung denkbar wie beispielsweise ein Spannungsmesser. Es ist auch eine Kommunikationsschnittstelle denkbar, über die die Magnetsteuerung Information von intelligenten Sensoren oder einer Haustechnik oder der Steuerung des Magnetresonanztomographen darüber erhält, beispielsweise von einer unterbrechungsfreien Stromversorgung über den Netzzustand und/oder einer verbleibenden Kapazität.

Die Sensoren bzw. die Schnittstelle ermöglichen der Magnetsteuerung ein selbständiges und adaptives Reagieren auf die Umgebungsbedingungen ohne einen Eingriff einer Bedienperson und ermöglicht so einen möglichst langen und störungsfreien Betrieb, insbesondere das Aufrechterhalten des Magnetfeldes des supraleitenden Feldmagnets.

In einer möglichen Ausführungsform des erfindungsgemäßen Magnetresonanztomographen weist der Magnetresonanztomograph eine erfindungsgemäße Magnetsteuerung auf. Die Magnetsteuerung kann als eine separate Einheit, mehrere separate Einheiten wie zum Beispiel ein eigner Steuerrechner und ein Kühlaggregat ausgeführt sein, oder auch als integraler Bestandteil des Magnetresonanztomographen. Denkbar ist beispielsweise, dass der Steuerrechner der Magnetsteuerung gleichzeitig Steuerrechner des Magnetresonanztomographen ist und in dieser als Programm realisiert ist.

Die Magnetsteuerung und der Magnetresonanztomograph sind in einer Ausführungsform dazu ausgebildet, in dem ersten Betriebszustand die Gradientenspule als Wärmesenke für eine Kühlung des supraleitenden Feldmagneten zu nutzen. Beispielsweise kann ein Kühlkreislauf der Gradientenspule über ein von der Magnetsteuerung schaltbares Ventil mit einem Kühlkreislauf eines Primärkühlers des Kühlaggregats der Magnetsteuerung verbunden sein, sodass die Magnetsteuerung warmes Kühlwasser von dem Primärkühler zu der Gradientenspule leiten kann und diese so erwärmt wird. Auf vorteilhafte Weise kann die Gradientenspule aufgrund der großen Masse, sofern sie nicht bereits durch eine Bilderfassung aufgeheizt ist, einige Zeit als Wärmesenke dienen, insbesondere, wenn gerade keine Bilderfassung erfolgt, die die Gradientenspule erhitzt.

Die oben beschriebenen Eigenschaften, Merkmale und Vorteile dieser Erfindung sowie die Art und Weise, wie diese erreicht werden, werden klarer und deutlicher verständlich im Zusammenhang mit der folgenden Beschreibung der Ausführungsbeispiele, die im Zusammenhang mit den Zeichnungen näher erläutert werden.

Es zeigen:
- Fig. 1: eine schematische Darstellung eines beispielhaften erfindungsgemäßen Magnetresonanztomographen mit einer erfindungsgemäßen Magnetsteuerung;
- Fig. 2: eine schematische Darstellung einer beispielhaften erfindungsgemäßen Magnetsteuerung;
- Fig. 3: schematisch einen beispielhaften Kühlmittelkreislauf einer denkbaren Ausführungsform eines erfindungsgemäßen Magnetresonanztomographen;
- Fig. 4: einen schematischer Ablaufplan für ein Verfahren zum Betrieb des erfindungsgemäßen Magnetresonanztomographen.

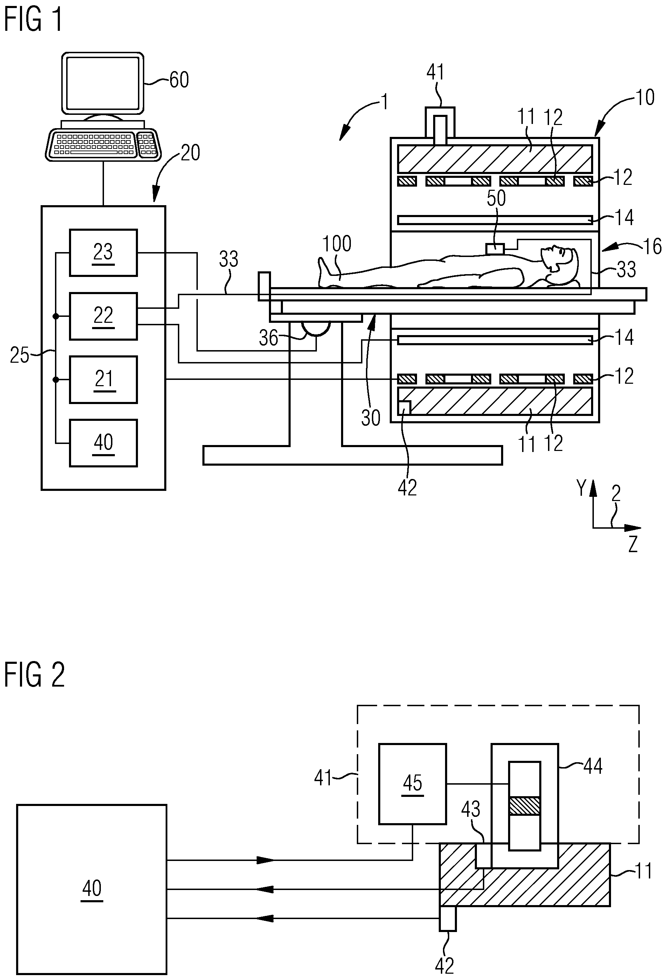

Fig. 1 zeigt eine schematische Darstellung einer Ausführungsform eines beispielhaften erfindungsgemäßen Magnetresonanztomographen 1.

Die Magneteinheit 10 weist einen Feldmagneten 11 auf, der ein statisches Magnetfeld B0 zur Ausrichtung von Kernspins von Proben bzw. des Patienten 100 in einem Aufnahmebereich erzeugt. Der Aufnahmebereich zeichnet sich durch ein äußerst homogenes statisches Magnetfeld B0 aus, wobei die Homogenität insbesondere die Magnetfeldstärke bzw. den Betrag betrifft. Der Aufnahmebereich ist nahezu kugelförmig und in einem Patiententunnel 16 angeordnet, der sich in einer Längsrichtung 2 durch die Magneteinheit 10 erstreckt. Eine Patientenliege 30 ist in dem Patiententunnel 16 von der Verfahreinheit 36 bewegbar. Der Feldmagneten 11 ist ein supraleitender Feldmagnet, der magnetische Felder mit einer magnetischen Flussdichte von bis zu 3T, bei neuesten Geräten sogar darüber, bereitstellen kann.

Der supraleitende Feldmagnet 11 benötigt zur Aufrechterhaltung der niedrigen Temperaturen der supraleitenden Magnetspulen ein Kühlaggregat mit hohem Stromverbrauch und gleichermaßen hoher Abwärme und damit Kühlbedarf.

Weiterhin weist die Magneteinheit 10 Gradientenspulen 12 auf, die dazu ausgelegt sind, zur räumlichen Differenzierung der erfassten Abbildungsbereiche in dem Untersuchungsvolumen dem Magnetfeld B0 zeitlich und räumlich variable Magnetfelder in drei Raumrichtungen zu überlagern. Die Gradientenspulen 12 sind üblicherweise Spulen aus normalleitenden Drähten, die zueinander orthogonale Felder in dem Untersuchungsvolumen erzeugen können.

Auch die resistiven Gradientenspulen 12 werden von einer Gradientensteuerung 21 mit sehr hohen Strömen angesteuert und haben einen entsprechenden Bedarf an elektrischer Energie und Kühlbedarf für die Abwärme. Sie sind deshalb vorzugsweise mit einem Kühlkreislauf verbunden. Auch weisen die Gradientenspulen 12 aufgrund ihrer großen Masse eine erhebliche Wärmekapazität auf.

Die Magneteinheit 10 weist ebenfalls eine Körperspule 14 auf, die dazu ausgelegt ist, ein über eine Signalleitung zugeführtes Hochfrequenzsignal in das Untersuchungsvolumen abzustrahlen und von dem Patient 100 emittierte Resonanzsignale zu empfangen und über eine Signalleitung abzugeben.

Eine Steuereinheit 20 versorgt die Magneteinheit 10 mit den verschiedenen Signalen für die Gradientenspulen 12 und die Körperspule 14 und wertet die empfangenen Signale aus.

So weist die Steuereinheit 20 eine Gradientenansteuerung 21 auf, die dazu ausgelegt ist, die Gradientenspulen 12 über Zuleitungen mit variablen Strömen zu versorgen, welche zeitlich koordiniert die erwünschten Gradientenfelder in dem Untersuchungsvolumen bereitstellen.

Die Magnetsteuerung 40 der Steuereinheit 20 steuert und überwacht den supraleitenden Feldmagneten 11 bzw. dessen Kühlaggregat 41 mittels Sensoren, beispielsweise mit einem Temperatursensor 42 an dem supraleitenden Feldmagneten 11 oder einem Drucksensor 43, der den Druck eines Kühlmittels des Kühlaggregats 41 aufnimmt und damit indirekt auch eine Temperatur des Kühlmittels und des damit in thermischem Kontakt stehenden Feldmagneten 11 wiedergibt. Insbesondere ist die Magnetsteuerung 40 ausgebildet, das Kühlaggregat mit mindestens einer Leistungsstufe zwischen einem ausgeschalteten Zustand und einem Betrieb mit maximaler Kühlleistung zu betreiben. Vorzugsweise gibt es mehrere Betriebszustände mit unterschiedlicher Kühlleistung oder eine stufenlos einstellbare Külleistung, wie es mit Kompressoren mit stufenlosem Inverter eines Kühlaggregats 41 möglich ist.

Weiterhin weist die Steuereinheit 20 eine Hochfrequenzeinheit 22 auf, die ausgelegt ist, einen Hochfrequenz-Puls mit einem vorgegebenen zeitlichen Verlauf, Amplitude und spektraler Leistungsverteilung zur Anregung einer Magnetresonanz der Kernspins in dem Patienten 100 zu erzeugen. Dabei können Pulsleistungen im Bereich von Kilowatt erreicht werden. Die Anregungssignale können über die Körperspule 14 oder auch über eine lokale Sendeantenne in den Patienten 100 abgestrahlt werden.

Eine Gerätesteuerung 23 kommuniziert über einen Signalbus 25 mit der Gradientensteuerung 21, der Hochfrequenzeinheit 22 und der Magnetsteuerung 40.

Zum Empfang des Magnetresonanzsignals ist eine erfindungsgemäße Lokalspule 50 auf dem Patienten 100 im Patiententunnel 16 angeordnet, um Magnetresonanzsignale aus einem Untersuchungsbereich in unmittelbarer Nähe mit möglichst großem Rauschabstand zu erfassen. Die Lokalspule 50 ist über eine Anschlussleitung 33 mit einem Empfänger in der Hochfrequenzeinheit 22 in Signalverbindung.

Der Magnetresonanztomograph 1 kann eine Schnittstelle aufweisen, beispielsweise zu einem Datennetzwerk, über das die Gerätesteuerung 23 mit einer Versorgungseinrichtung kommunizieren kann, beispielsweise Nachrichten senden und Anweisungen empfangen. Aus diese Weise kann die Gerätesteuerung 23 eine Information über eine Verfügbarkeit einer Kühlressource wie elektrischer Energie, eine Sekundärkühlung oder Kühlwasser empfangen und an die Magnetsteuerung weitergeben. Es ist aber auch denkbar, dass die Magnetsteuerung 40 selbst über eine derartige Schnittstelle aufweist, beispielsweise einen Sensor für eine Kühlwassertemperatur oder einen Spannungswächter für die Stromversorgung.

In Fig. 2 sind die funktionalen Zusammenhänge der Magnetsteuerung 40 mit Kühlaggregat 41 und den Sensoren 42, 43 einer möglichen Ausführungsform schematisch dargestellt.

Die Magnetsteuerung 40 steuert die Kühlleistung des Kühlaggregats 41 über den Kompressor 45, der mittels eines Inverters in seiner Leistung regelbar ist. Der Kompressor 45 liefert ein Fluid unter Druck für einen Pulsröhrenkühler 44. An dessen Kaltkopf kann sich beispielsweise ein Reservoir an flüssigem Helium befinden, dessen Druck mit einem Drucksensor 43 von der Magnetsteuerung 40 erfasst wird. Der Druck wiederum ist ein Maß für die Temperatur des Reservoirs und damit in thermischem Kontakt stehenden Elementen wie dem supraleitenden Feldmagneten 11. Ebenso ist es denkbar, dass die Magnetsteuerung 40 über einen Temperatursensor 42 direkt eine Temperatur des supraleitenden Feldmagneten 11 erfasst.

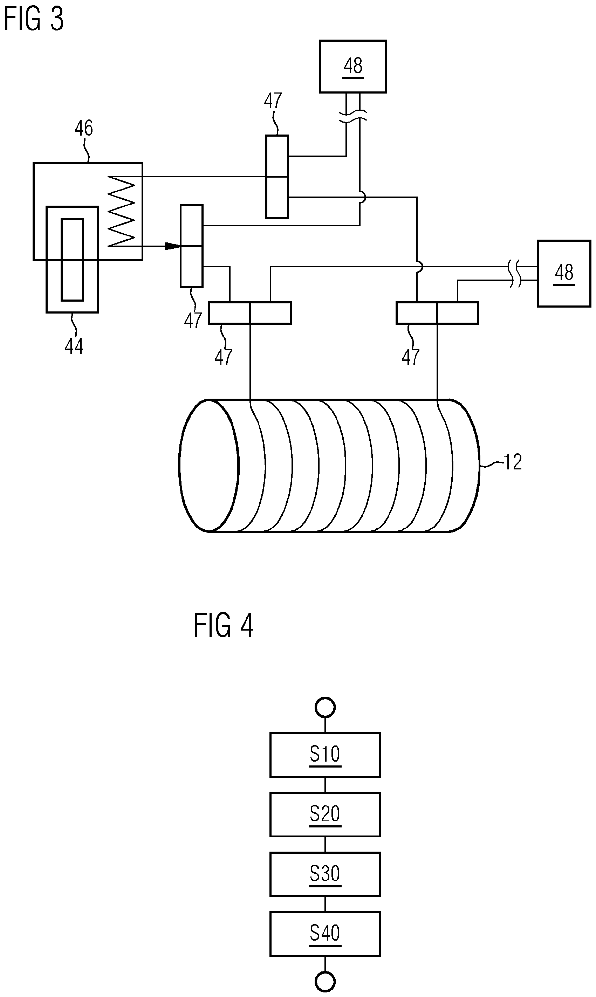

Fig. 3 stellt schematisch einen beispielhaften Kühlmittelkreislauf einer denkbaren Ausführungsform eines erfindungsgemäßen Magnetresonanztomographen 1 dar.

Das Kühlaggregat 40 bzw. in dem dargestellten Beispiel der Pulsröhrenkühler 44 muss zur Abfuhr der aus dem Feldmagneten 11 abgeführten Wärme einschließlich der Verlustwärme des Kompressors 45 gekühlt werden. Repräsentativ ist in Fig.3 als Wärmequelle der Heißkopf des Pulsröhrenkühlers 44 dargestellt, der in Wärmekontakt mit einem Wärmetauscher 46 an ein Kühlmittel, beispielsweise Kühlwasser, abgibt. Die Wärme wird von dem Kühlmittel an eine Wärmesenke 48 übertragen. Die Wärmesenke 48 kann beispielsweise ein Sekundärkühler sein oder auch eine Kaltwasserquelle.

In einer möglichen Ausführungsform des erfindungsgemäßen Magnetresonanztomographen 1 kann die Magnetsteuerung 40 oder die Steuerung 20 über Ventile 47 das Kühlaggregat mit unterschiedlichen Wärmesenken 48 verbinden. Insbesondere ist es denkbar, dass in dem ersten Betriebsmodus ohne Bilderfassung die Einstellung der Ventile 47 in dem ersten Betriebsmodus derart erfolgt, dass die Gradientenspule 12 als Wärmesenke dient. Die Gradientenspule 12 erzeugt während der Bilderfassung durch die Gradientenströme erhebliche Abwärmemengen, die durch einen Kühlwasserkreislauf abgeführt werden muss. Gleichzeitig hat die Gradientenspule aufgrund der mechanischen Belastungen eine massive Konstruktion mit großer Masse und damit Wärmekapazität. Mittels der Ventile 47 ist der Kühlmittelkreislauf des Kühlaggregats 40, hier im Bild der Wärmetauscher 46, mit dem Kühlkreislauf der Gradientenspule 12 derart verbindbar, dass das Kühlmittel Wärme von dem Wärmetauscher 46 an die Gradientenspule 12 überträgt.

In Fig. 4 ist ein Ablaufplan für ein Verfahren zum Betrieb des erfindungsgemäßen Magnetresonanztomographen schematisch dargestellt.

In einem Schritt S10 des Verfahrens erfasst der Magnetresonanztomograph 1 eine Verfügbarkeit einer Ressource zum Kühlen des supraleitenden Magneten. Dies kann beispielsweise durch die Gerätesteuerung 23 des Magnetresonanztomographen 1 über die zuvor beschriebene Schnittstelle erfolgen. Denkbar ist, dass eine Haustechnik oder USV eine Nachricht über einen Stromausfall und eine begrenzte Verfügbarkeit an elektrischer Energie oder Kühlwasser an die Gerätesteuerung 23 sendet. Es könnte aber auch die Magnetsteuerung 40 über einen Sensor selbst eine Verfügbarkeit überwachen, beispielsweise über einen Temperatursensor 42 eine Kühlwassertemperatur. Insbesondere kann die Magnetsteuerung 40 oder die Gerätesteuerung 23 so auch einen Mangel an einer Kühlressource wie elektrischer Energie, Kühlmittel oder einer Sekundärkühlung erfassen.

In einem weiteren Schritt S20 stellt die Magnetsteuerung 40 den ersten Betriebsmodus in Abhängigkeit von der Verfügbarkeit der Kühlressource ein. Vorzugsweise erfolgt dies, wenn eine Information über einen Mangel an der Kühlressource bei der Magnetsteuerung 40 vorliegt

Die Steuerung 23 nimmt dann vorzugsweise keine Bilderfassung mehr vor, wenn sie selbst den Mangel an der Kühlressource erfasst oder den ersten Betriebszustand von der Magnetsteuerung 40 übermittelt bekommt.

Die Magnetsteuerung 40 betreibt dann das Kühlaggregat derart, dass ein reduzierter Bedarf an der Kühlressource gegeben ist. Die Magnetsteuerung 40 fährt dazu die Kühlleistung des Kühlaggregats 41 herunter, ohne es aber gänzlich über längere Zeit, beispielsweise über mehr als 0,01 s, 0,1 s oder 1 s auszuschalten. Vorzugsweise bildet sich so ein stationärer Zustand des Kühlaggregats und des supraleitenden Feldmagneten 11 aus, bei dem der supraleitende Feldmagnet 11 eine höhere Temperatur mit einem geringeren Kühlleistungsbedarf als im zweiten Betriebsmodus einnimmt, aber noch kalt genug ist, um den supraleitenden Stromfluss nicht zu quenchen. Dies kann beispielsweise mit einem Kompressor mit einem Inverter zum Einstellen der Leistung realisiert werden. Denkbar ist es auch, dass die Magnetsteuerung 40 das Kühlaggregat 41 dabei aktiv regelt, sodass eine durch einen Temperatursensor 42 erfasste Temperatur des Feldmagneten 11 oder ein Druck des Kühlmittels, erfasst mit einem Drucksensor 43, einen Schwellwert nicht überschreitet, bei dem der supraleitende Stromfluss erhalten bleibt.

Es ist dabei denkbar, dass die Magnetsteuerung 40 und/oder die Gerätesteuerung 23 mittels der Ventile 47 den Kühlmittelffluss von dem Wärmetauscher 46 derart mit einem Kühlmittelkreislauf der Gradientenspule 12 verbindet, dass die Gradientenspule 12 als Wärmesenke für das Kühlaggregat 41 dient.

In einem Schritt S30 wird der supraleitenden Feldmagnet 11 in dem ersten Betriebsmodus mit reduziertem Bedarf an der Kühlressource betrieben. Während des Kühlens im zweiten Betriebsmodus erfolgt keine Bilderfassung durch den Magnetresonanztomographen 1.

Vorzugsweise wird in einem Schritt S40 von der Magnetsteuerung 40 mit Verfügbarkeit der Kühlressource wieder der zweite Betriebszustand eingestellt, bei dem wieder eine Bilderfassung möglich ist, ohne dass der supraleitende Feldmagnet 11 durch den zusätzlichen Wärmeeintrag quencht.

Obwohl die Erfindung im Detail durch das bevorzugte Ausführungsbeispiel näher illustriert und beschrieben wurde, so ist die Erfindung nicht durch die offenbarten Beispiele eingeschränkt und andere Variationen können vom Fachmann hieraus abgeleitet werden, ohne den Schutzumfang der Erfindung zu verlassen.

## Patentansprüche

1. Magnetsteuerung für einen supraleitenden Feldmagneten (11) eines Magnetresonanztomographen (1), wobei die Magnetsteuerung (40) ausgebildet ist, einen ersten Betriebsmodus und einen zweiten Betriebsmodus des supraleitenden Feldmagneten (11) einzustellen, wobei der erste Betriebsmodus ein Betriebsmodus mit reduziertem Kühlressourcenverbrauch ist und der zweite Betriebsmodus ein Betriebsmodus mit einer verbesserten Magnetfeldqualität für eine Magnetresonanzaufnahme.

2. Magnetsteuerung nach Anspruch 1, wobei der erste Betriebsmodus ausgelegt ist, ein Quenching des supraleitenden Feldmagneten (11) nur ohne Magnetresonanzmessung zu verhindern.

3. Magnetsteuerung nach Anspruch 1 oder 2, wobei die Magnetsteuerung (40) ein Kühlaggregat (41) aufweist, welches mindestens drei einstellbare unterschiedliche Leistungsstufen aufweist und die Magnetsteuerung (40) ausgebildet ist, in dem ersten Betriebsmodus das Kühlaggregat (41) mit einer Leistungsstufe zu betreiben, die kleiner einer maximalen Leistungsstufe ist.

4. Magnetsteuerung nach Anspruch einem der vorhergehenden Ansprüche, wobei der erste Betriebsmodus einen ersten Magnetparametersatz angibt, der bei Einhaltung durch die Magnetsteuerung (40) eine vorbestimmte thermische und/oder magnetische Belastbarkeit für den supraleitenden Feldmagneten (11) herbeiführt, die geringer ist als in dem zweiten Betriebsmodus.

5. Magnetsteuerung nach Anspruch 4, wobei der zweite Betriebsmodus einen zweiten Parametersatz angibt, wobei der zweite Parametersatz bei Einhaltung durch die Magnetsteuerung (40) zu einer besseren Eignung des supraleitenden Feldmagneten (11) für eine Bildgebung führt.

6. Magnetsteuerung, wobei die Magnetsteuerung (40) ausgebildet ist, den ersten Betriebsmodus in Abhängigkeit von einer Verfügbarkeit einer Kühlressource einzustellen.

7. Magnetsteuerung nach Anspruch 6, wobei die Kühlressource elektrischer Energie und/oder eine Sekundärkühlung ist.

8. Magnetresonanztomograph mit einer Magnetsteuerung (40) nach einem der vorhergehenden Ansprüche, wobei die Magnetsteuerung (40) und der Magnetresonanztomograph (1) ausgebildet sind, in dem ersten Betriebszustand die Gradientenspule (12) als Wärmesenke für eine Kühlung des supraleitenden Feldmagneten (11) zu nutzen.

9. Verfahren zum Betrieb eines Magnetresonanztomographen (1) mit einer Magnetsteuerung (40) nach einem der Ansprüche 1 bis 7, wobei das Verfahren die Schritte aufweist:
- Erfassen einer Verfügbarkeit (S10) einer Ressource zum Kühlen des supraleitenden Feldmagneten (11) durch die Magnetsteuerung (40);
- Einstellen des ersten Betriebsmodus (S20) in Abhängigkeit von der Verfügbarkeit;
- Kühlen des supraleitenden Feldmagneten (11) gemäß dem ersten Betriebsmodus,
wobei keine Bilderfassung durch den Magnetresonanztomographen (1) erfolgt.
